# EUROPÄISCHE PATENTSCHRIFT

(11) **EP 0 538 806 B1**
(45) Veröffentlichungstag und Bekanntmachung des Hinweises auf die Patenterteilung: **11.01.1995**
(21) Anmeldenummer: 92117947.9
(22) Anmeldetag: 20.10.1992
(51) Int. Cl.: H03G 11/04, H03G 7/00

(54) **Schaltungsanordnung zur Signalbegrenzung und Feldstärkedetektion**
Circuit for signal limiting and signal strength detection
Circuit de limitation de signaux et de détection de l'intensité du champ

(30) Priorität: 25.10.1991 DE 4135319
(43) Veröffentlichungstag der Anmeldung: 28.04.1993
(73) Patentinhaber: SIEMENS AKTIENGESELLSCHAFT, 80333 München (DE)
(72) Erfinder: Fenk, Josef, Dipl.-Ing., W-8057 Eching/Ottenburg (DE); Sehrig, Peter, Ing., W-8134 Pöcking (DE)

(56) Entgegenhaltungen:
- IEEE 1990 Bipolar Circuits and Technology Meeting, Mineapolis, 17 - 18September, 1990, pages 244 - 247, IEEE, New York US; J. Fenk et al.: "An RFFront - End for Digital Mobile Radio"

## Beschreibung

Die Erfindung betrifft eine Schaltungsanordnung zur Signalbegrenzung und Feldstärkedetektion nach dem Oberbegriff des Patentanspruches 1.

Bei Empfangsschaltungen in der Rundfunk- und Fernsehtechnik sowie in der Mobilfunktechnik werden häufig sogenannte Feldstärkemonitore benötigt. Wie aus J. Fenk, W. Birth, R.G. Irvine, P. Sehrig, K.R. Schön, An RF Front-End For Digital Mobil Radio, IEEE 1990, Bipolar Circuits and Technology Meeting 11.2, bekannt ist, bestehen ein derartige Feldstärkemonitore beispielsweise aus einem mehrstufigen, in diesem Fall siebenstufigen Begrenzerverstärker, an den eine siebenstufige Feldstärkedetektorschaltung angeschlossen ist. Die Eingangsspannung des Feldstärkemonitors wird mittels der Begrenzerverstärkerstufen in Gleichströme gewandelt. Diese werden aufaddiert und erzeugen an einem internen Widerstand eine Spannung (RSSI). Um die Feldstärkemonitore bei einer Vielzahl von Frequenzen einsetzen zu können, sind diese relativ breitbandig ausgelegt. Die Breitbandigkeit führt zusammen mit der relativ hohen Verstärkung aller Begrenzerverstärkerstufen einschließlich des Vorverstärkers zu starkem Rauschen. Das bedeutet wiederum, daß bei Unterschreitung eines bestimmten Wertes der Eingangsspannung die Spannung am internen Widerstand (RSSI) nurmehr dem Rauschpegel entspricht. Erhöht wird der Rauschpegel dabei zusätzlich noch durch eine gemeinsame Ansteuerung des Feldstärkemonitors und einer Verstärkungsregelstufe, wobei die Eingangsimpedanz des Feldstärkemonitors hochohmig und die der Verstärkungsregelstufe niederohmig ist. Dadurch tritt eine Fehlanpassung zwischen dem Feldstärkemonitor und einem vorgeschalteten Filter auf, was zu einem Ansteigen des Rauschpegels führt.

Aufgabe der Erfindung ist es daher, eine Schaltungsanordnung zur Signalbegrenzung und Feldstärkedetektion mit geringerem Rauschen anzugeben.

Diese Aufgabe wird bei einer gattungsgemäßen Schaltungsanordnung durch die kennzeichnenden Merkmale des Patentanspruches 1 gelöst. Ausgestaltungen und Weiterbildungen der Erfindung sind Gegenstand von Unteransprüchen.

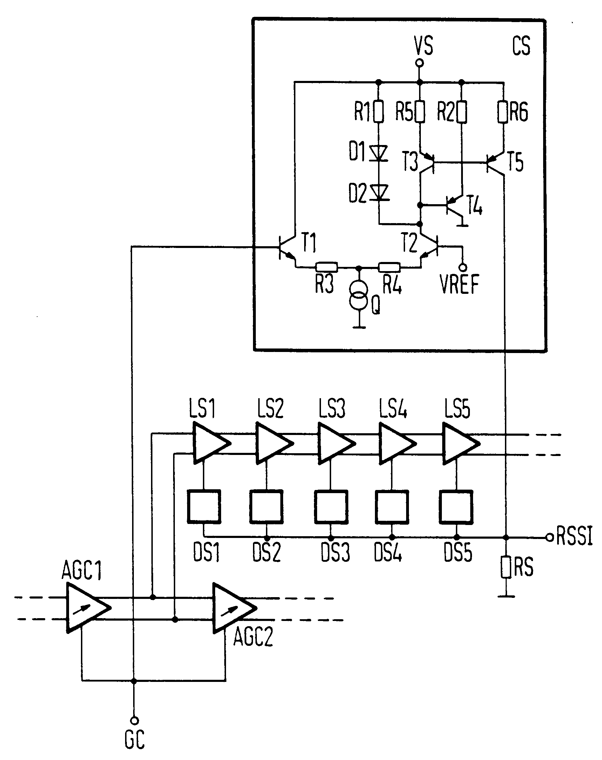

Die Erfindung wird nachfolgend anhand des in der einzigen Figur der Zeichnung dargestellten Ausführungsbeispiels näher erläutert.

Bei dem in der Zeichnung dargestellten Ausführungsbeispiel ist eine Monitorschaltung dargestellt bestehend aus fünf hintereinandergeschalteten Begrenzerverstärkerstufen LS1 bis LS5 und aus fünf Detektorstufen DS1 bis DS5, die jeweils durch eine der Begrenzerverstärkerstufen LS1 bis LS5 angesteuert werden und deren Stromausgänge miteinander verbunden sind. Der Monitorschaltung ist eine Verstärkerschaltung AGC1 vorgeschaltet, deren Verstärkung von einem Kontrollsignal GC abhängt. Von dem Kontrollsignal GC hängt in gleicher Weise zudem der Ausgangsstrom einer Stromquellenschaltung CS ab, deren Ausgang mit den Stromausgängen der Detektorstufen DS1 bis DS5 verbunden ist.

Die Erfindung ausgestaltend ist der Verstärkerschaltung AGC1 eine weitere Verstärkerschaltung AGC2 nachgeschaltet, deren Eingangsimpedanz auf die Eingangimpedanz der Monitorschaltung und auf die Ausgangsimpedanz der Verstärkerschaltung AGC1 abgestimmt ist.

Die Stromquellenschaltung CS weist in Weiterbildung der Erfindung eine durch das Kontrollsignal GC angesteuerte Differenzverstärkerstufe mit zwei über jeweils einen Widerstand R3 bzw. R4 emittergekoppelten und aus einer Stromquelle Q gespeisten npn-Transistoren T1 und T2 auf. Der Kollektor des Transistors T1 ist mit einem Versorgungspotential VS direkt der Kollektor des Transistors T2 zum einen über einen Widerstand R1 und zwei in Reihe dazu geschalteten Dioden D1, D2 und zum anderen über die Kollektor-Emitter-Strecke eines pnp-Transistors T3 mit dem Versorgungspotential VS verbunden ist. Die Basis des Transistors T3 ist über einen Widerstand R2 ebenfalls an das Versorgungspotential VS angeschlossen und darüber hinaus mit dem Emitter eines pnp-Transistors T4 sowie der Basis eines pnp-Transistors T5 verbunden. Beim Transistor T4 ist die Basis an den Kollektor des Transistors T3 und der Kollektor an ein Bezugspotential angeschlossen. Der Kollektor des Transistors T5, dessen Emitter mit dem Versorgungspotential VS gekoppelt ist, bildet den Ausgang der Stromquellenschaltung CS. Der Ausgang der Stromquellenschaltung CS ist ebenso wie die Ausgänge der Detektorschaltungen DS1 bis DS5 über einen Widerstand RS an das Bezugspotential angeschlossen. An dem Widerstand RS liegt eine Spannung RSSI an, die das Ausgangssignal der Monitorschaltung darstellt.

Durch das Vorschalten eines steuerbaren Verstärkers AGC1 vor die Monitorschaltung, insbesondere wenn der steuerbare Verstärker Bestandteil einer Verstärkungsregelanordnung ist, bewirkt daß die Dynamik der Monitorschaltung erhöht wird ohne dabei den Rauschpegel absolut zu erhöhen. Dabei kann ein dem Monitorverstärker üblicherweise vorgeschalteter Vorverstärker mit konstanter Verstärkung entfallen, was zu einer Verminderung des Rauschpegels beiträgt. Weiterhin wird der Rauschpegel dadurch herabgesetzt, daß die Monitorschaltung und ebenso ein weiterer Verstärker, beispielsweise wiederum ein steuerbarer Verstärker AGC2, aneinander und an den Verstärker AGC1 angepaßt werden. Günstig ist dabei, daß die Eingangsimpedanzen der Monitorschaltung und des Verstärkers AGC2 sowie die Ausgangsimpedanz des Verstärkers AGC1 hochohmig sind. Dabei können die beiden Verstärker AGC1 und AGC2 ein- oder mehrstufig ausgeführt sein und insgesamt bei entsprechender Steuerung mittels des Kontrollsignals GC eine Verstärkerungsregelanordnung bilden. Das Kontrollsignal GC ist dabei auf eine nicht näher beschriebene Weise von der Spannung RSSI abgeleitet. Aufgrund der vorstehend aufgezeigten Maßnahmen wird der Dynamikbereich der gesamten Schaltungsanordnung derart erhöht, daß gegenüber bisher bekannten Schaltungsanordnungen die Zahl der Begrenzerverstärkerstufen herabgesetzt werden kann, wodurch der Rauschpegel weiter gesenkt wird. Damit ergibt sich bei gleicher effektiver Dynamik ein wesentlich geringerer Rauschpegel als bei bisher bekannten Konzepten.

Durch das Vorschalten eines steuerbaren Verstärkers ergibt sich ein von jeweiligen Verstärkung ab hängiger Zusammenhang zwischen der Spannung RSSI und einem am Eingang des Verstärkers AGC1 anliegenden Signales. Bei einer Verstärkungsregelanordnung ergibt sich demzufolge ein nichtlinearer Verlauf, der mittels der Stromquellenschaltung CS wieder linearisiert wird. Die Widerstände R1, R3 und R4 sowie die Dioden D1 und D2 werden dabei bevorzugt auf die Verstärkungscharakteristik des Verstärkers AGC1 in Abhängigkeit vom Kontrollsignal GC abgestimmt.

Schließlich sei daraufhingewiesen, daß die beiden Verstärker AGC1 und AGC2 sowie die Begrenzerverstärkerstufen LS1 bis LS5 und die Detektorstufen DS1 bis DS5 beispielsweise mit den Verstärkern, Begrenzerstufen bzw. Detektorstufen der eingangs genannten bekannten Schaltungsanordnung identisch sind.

## Patentansprüche

1. Schaltungsanordnung
mit einer Monitorschaltung bestehend aus n hintereinander geschalteten Begrenzerverstärkerstufen (LS1 bis LS5) und aus n Detektorstufen (DS1 bis DS5), die jeweils durch eine der Begrenzerverstärkerstufen (LS1 bis LS5) angesteuert werden und deren Stromausgänge miteinander verbunden sind,
**gekennzeichnet durch** eine Verstärkerschaltung (AGC1), die der Monitorschaltung vorgeschaltet ist und deren Verstärkung von einem Kontrollsignal (GC) abhängt, und durch eine Stromquellenschaltung (CS), deren Ausgang mit den Stromausgängen der Detektorschaltungen (DS1 bis DS5) verbunden ist und deren Ausgangsstrom ebenfalls von dem Kontrollsignal (GC) abhängt.

2. Schaltungsanordnung nach Anspruch 1,
**dadurch gekennzeichnet**, daß die Stromquellenschaltung (CS) eine durch das Kontrollsignal (GG) angesteuerte Differenzverstärkerstufe mit zwei emittergekoppelten und aus einer Stromquelle (Q) gespeisten Transistoren (T1, T2) aufweist,
daß bei einem der beiden emittergekoppelten Transistoren (T2), der Kollektor zum einen über einen ersten Widerstand (R1) und zwei in Reihe dazu geschaltete Dioden (D1, D2) und zum anderen über die Kollektor-Emitter-Strecke eines dritten Transistors (T3) mit einem Versorgungspotential (VS) verbunden ist,
daß die Basis des dritten Transistors (T3), über einen zweiten Widerstand (R2) an dem Versorgungspotential (VS) angeschlossen ist und mit dem Emitter eines vierten Transistors (T4) sowie der Basis eines fünften Transistors (T5) verbunden ist,
daß beim vierten Transistor (T4) die Basis an den Kollektor des dritten Transistors (T3) und der Kollektor an ein Bezugspotential angeschlossen ist, und
daß der Kollektor des fünften Transistors (T5), dessen Emitter mit dem Versorgungspotential (VS) gekoppelt ist, den Ausgang der Stromquellenschaltung (CS) bildet.

3. Schaltungsanordnung nach Anspruch 1 oder 2,
**dadurch gekennzeichnet**, daß der Verstärkerschaltung (AGC1) eine weitere Verstärkerschaltung (AGC2) nachgeschaltet ist, deren Eingangsimpedanz auf die Eingangsimpedanz der Monitorschaltung und auf die Ausgangsimpedanz der einen Verstärkerschaltung (AGC1) abgestimmt ist.

## Claims

1. Circuit arrangement having a monitor circuit comprising n series-connected limiting amplifier stages (LS1 to LS5) and n detector stages (DS1 to DS5) which are driven in each case by one of the limiting amplifier stages (LS1 to LS5) and whose current outputs are connected to each other, characterized by an amplifier circuit (AGC1) which is connected upstream of the monitor circuit and whose amplification is a function of a control signal (GC), and by a current source circuit (CS) whose output is connected to the current outputs of the detector circuits (DS1 to DS5) and whose output current likewise is a function of the control signal (GC).

2. Circuit arrangement according to Claim 1, characterized in that the current source circuit (CS) has a differential amplifier stage which is driven by the control signal (GC) and has two emitter-coupled transistors (T1, T2) supplied from one current source (Q), in that in the case of one of the two emitter-coupled transistors (T2) the collector is connected to a supply potential (VS) on the one hand via a first resistor (R1) and two diodes (D1, D2) connected in series thereto and, on the other hand, via the collector-emitter path of a third transistor (T3), in that the base of the third transistor (T3) is connected via a second resistor (R2) to the supply potential (VS) and to the emitter of a fourth transistor (T4) as well as the base of a fifth transistor (T5), in that in the case of the fourth transistor (T4) the base is connected to the collector of the third transistor (T3) and the collector to a reference potential, and in that the collector of the fifth transistor (T5), whose emitter is coupled to the supply potential (VS), forms the output of the current source circuit (CS).

3. Circuit arrangement according to Claim 1 or 2, characterized in that downstream of the amplifier circuit (AGC1) there is connected a further amplifier circuit (AGC2) whose input impedance is matched to the input impedance of the monitor circuit and to the output impedance of the one amplifier circuit (AGC1).

## Revendications

1. Montage comportant un circuit de contrôle constitué de n étages amplificateurs-limiteurs (LS1 à LS5) branchés en série et de n étages détecteurs (DS1 à DS5), qui sont commandés chacun par l'un des étages amplificateurs-limiteurs (LS1 à LS5) et dont les sorties de courant sont reliées entre elles,
caractérisé par un circuit amplificateur (AGC1), qui est branché en amont du circuit de contrôle et dont le gain dépend d'un signal de contrôle (GC), et par un circuit formant source de courant (CS), dont la sortie est reliée aux sorties de courant des circuits détecteurs (DS1 à DS5) et dont le courant de sortie dépend également du signal de contrôle (GC).

2. Montage suivant la revendication 1, caractérisé par le fait que le circuit formant source de courant (CS) possède un étage amplificateur différentiel commandé par le signal de contrôle (GC) et comportant deux transistors (T1,T2) couplés par leurs émetteurs et alimentés par une source de courant (Q),
que, dans l'un (T2) des deux transistors à émetteurs couplés, le collecteur est relié d'une part par l'intermédiaire d'une première résistance (R1) et de deux diodes (D2,D2) branchées en série avec cette résistance, et d'autre part par l'intermédiaire de la section collecteur-émetteur d'un troisième transistor (T3), à un potentiel d'alimentation (VS),
que la base du troisième transistor (T3) est reliée par l'intermédiaire d'une seconde résistance (R2) au potentiel d'alimentation (VS) et est connectée à l'émetteur d'un quatrième transistor (T4) ainsi qu'à la base d'un cinquième transistor (T5),
que dans le quatrième transistor (T4), la base est raccordée au collecteur du troisième transistor (T3) et le collecteur est relié à un potentiel de référence, et
que le collecteur du cinquième transistor (T5), dont l'émetteur est accouplé au potentiel d'alimentation (VS), forme la sortie du circuit formant source de courant (CS).

3. Montage suivant la revendication 1 ou 2, caractérisé par le fait qu'en aval du circuit amplificateur (AGC1) est branché un autre circuit amplificateur (AGC2), dont l'impédance d'entrée est accordée sur l'impédance d'entrée du circuit de contrôle et sur l'impédance de sortie du circuit amplificateur (AGC1).
